# EUROPÄISCHE PATENTSCHRIFT

(11) **EP 2 972 419 B1**
(45) Veröffentlichungstag und Bekanntmachung des Hinweises auf die Patenterteilung: **15.08.2018**
(21) Anmeldenummer: 14713045.4
(22) Anmeldetag: 11.03.2014
(51) Int. Cl.: G01R 1/067, G01R 1/073, G01R 31/28

(54) **TRAVERSENEINHEIT FÜR EINE PRÜFVORRICHTUNG FÜR LEITERPLATTEN, SOWIE PRÜFVORRICHTUNG DAMIT**
CROSSMEMBER UNIT FOR A TEST APPARATUS FOR PRINTED CIRCUIT BOARDS, AND TEST APPARATUS HAVING SAID CROSSMEMBER UNIT
SYSTÈME DE TRAVERSE POUR DISPOSITIF D'ESSAI DE CIRCUITS IMPRIMÉS AINSI QUE DISPOSITIF D'ESSAI ÉQUIPÉ DE CE SYSTÈME

(30) Priorität: 13.03.2013 DE 102013102564; 13.03.2013 US 201361780501 P
(43) Veröffentlichungstag der Anmeldung: 20.01.2016
(73) Patentinhaber: Xcerra Corporation, Norwood, MA 02062 (US)
(72) Erfinder: ROMANOV, Victor, 97877 Wertheim (DE); OTT, Bernd-Ulrich, 74653 Künzelsau (DE)
(74) Vertreter: Patronus IP Patent- und Rechtsanwälte
(86) Internationale Anmeldenummer: PCT/EP2014/054727
(87) Internationale Veröffentlichungsnummer: WO 2014/140029

(56) Entgegenhaltungen:
- EP-A1- 0 468 153
- EP-A1- 0 853 242
- EP-A2- 0 458 280
- EP-A2- 1 217 382
- WO-A1-01/71371
- WO-A1-03/048787
- WO-A1-03/096037
- WO-A1-2004/099802
- DE-A1-102006 005 800
- DE-A1-102006 006 255

## Beschreibung

Die vorliegende Erfindung betrifft eine Traverseneinheit für eine Prüfvorrichtung für Leiterplatten und eine Prüfvorrichtung für Leiterplatten mit einer solchen Traverseneinheit.

Prüfvorrichtungen zum Testen von Leiterplatten können grundsätzlich in zwei Gruppen eingeteilt werden, die Gruppe der Fingertester (Flying Probe) und die Gruppe der Paralleltester. Die Paralleltester sind Prüfvorrichtungen, die mittels eines Adapters alle oder zumindest die meisten Kontaktstellen einer zu prüfenden Leiterplatte gleichzeitig kontaktieren. Fingertester sind Prüfvorrichtungen zum Testen von unbestückten oder bestückten Leiterplatten, die mit zwei oder mehreren Prüffingern die einzelnen Kontaktstellen sequenziell abtasten.

Die Prüffinger sind in der Regel an einem Schlitten befestigt, welcher entlang von Traversen verfahrbar ist, wobei die Traversen wiederum auf Führungsschienen geführt und verfahrbar sind. Die Prüffinger weisen jeweils einen Schwenkarm auf, an dessen Ende eine Kontaktspitze zum Kontaktieren einer Leiterplatte ausgebildet ist. Die Prüffinger können durch Verfahren des Schlittens und Drehen des Schwenkarmes somit mit ihren Kontaktspitzen an jede beliebige Stelle eines in der Regel rechteckförmigen Prüffeldes positioniert werden. Zum Kontaktieren einer Kontaktstelle einer zu prüfenden Leiterplatte ist entweder der Schlitten an der Traverse vertikal verschieblich oder die Prüfsonde am Schlitten vertikal beweglich ausgebildet, so dass der Prüffinger von oben bzw. von unten auf die Kontaktstelle der Leiterplatte, dem Leiterplattentestpunkt, gesetzt werden kann.

Ein Fingertester ist in der EP 0 468 153 A1 und ein Verfahren zum Prüfen von Leiterplatten mittels eines Fingertesters ist in der EP 0 853 242 A1 beschrieben. Prüfsonden für Fingertester gehen aus der EP 1 451 594 B1, der US 6,384,614 B1, der WO 03/096037 A1 und der EP 0 990 912 A2 hervor.

Üblicherweise werden für einen derartigen Fingertester mindestens zwei verfahrbare Kontaktfinger vorgesehen, um in einer ersten Koordinatenrichtung entlang der Traversenachse voneinander beabstandete Prüfpunkte erreichen zu können, und es werden mehrere Traversen oberhalb des Prüffeldes und (jedenfalls für die Prüfung beidseitig bedruckter Leiterplatten) mehrere Traversen unterhalb des Prüffeldes vorgesehen, um in einer zweiten Koordinatenrichtung quer zur Traversenachse voneinander beabstandete Prüfpunkte erreichen zu können. (Grundsätzlich kann man auch lediglich mit einem einzelnen Testfinger eine Leiterbahn testen, wenn man kapazitiv misst. In diesem Fall würde theoretisch nur ein Testfinger benötigt. Es wird aber bevorzugt, zwei Testfinger an einer Schiene anzuordnen, da man bei einer ohmschen Messung einen geschlossenen Stromkreis braucht und damit zwei Testfinger benötigt werden.) Für den Einsatz automatisierter Prüfverfahren mit einem Fingertester ist es wesentlich, dass die Relativpositionen der Traversen sowohl zueinander als auch zu dem Prüffeld genau bekannt sind. Bei dem in EP 0 468 153 A1 beschriebenen Fingertester sind die Traversen in einem Gestell - senkrecht zur Verfahrrichtung der Testfinger - verfahrbar gelagert. Aufgrund eines oft nicht vermeidbaren Spiels im Verfahren der Traversen weist der Abstand der Traversen eine gewisse Schwankungsbreite auf, und je nach dem eingesetzten Antriebssystem kann es aufgrund von Schlupferscheinungen vorkommen, dass der Abstand der Traversen aus einem vorgegebenen Toleranzfeld herauswandert und nachjustiert werden muss. Die damit verbundenen Justierungs- und Kalibrierungsvorgänge für wenigstens vier Traversen sind aufwändig und oft mit Ungenauigkeiten behaftet.

Es sind auch Fingertester bekannt, bei welchen die Traversen in einem Gestell ortsfest angeordnet sind. Da die Traversen einzelnen an einem Gestell sowohl ober- als auch unterhalb der Leiterplatte eingehängt sind, müssen sie einzeln sorgfältig justiert werden. Eine Länge der Schwenkarme kann im Hinblick auf einen Abstand zwischen den Traversen optimiert sein, um das Prüffeld zwischen den Traversen optimal erreichen zu können. Falls ein solcher Fingertester an geänderte Prozessbedingungen anzupassen ist, etwa weil die Abtastdichte erhöht oder erniedrigt werden soll, sind zusätzliche Traversen zu montieren bzw. vorhandene Traversen zu entfernen bzw. umzumontieren. Dabei ist ebenfalls ein erheblicher Aufwand für die Justierung der Traversen zueinander und zu dem Prüffeld und die Kalibrierung der Software erforderlich.

Aus der EP 0 458 280 A2 geht eine Vorrichtung zum Testen von Leiterplatten hervor, welche eine Vielzahl von separat verfahrbaren Traversen aufweist, wobei an jeder Traverse ein Prüfkopf mit einem Kontaktfinger zum Kontaktieren einer Kontaktstelle einer Leiterplatte vorgesehen ist.

Aus der EP 1 217 382 A2 geht eine weitere Vorrichtung zum Testen von Leiterplatten hervor, welche verfahrbare Traversen aufweist. An den verfahrbaren Traversen ist jeweils ein Prüfkopf beweglich angeordnet, an dem ein Kontaktfinger zum Kontaktieren eines Testpunktes einer Leiterplatte angeordnet ist.

In der WO 2004/099802 A1 ist ein Verfahren zum Testen von unbestückten Leiterplatten beschrieben. Gemäß diesem Verfahren ist vorgesehen, die Bewegung von Prüffingern nach einem tatsächlich erfassten Niveau der Oberfläche der Leiterplatte anzusteuern, so dass die Prüffinger mit hoher Geschwindigkeit bis an die Oberfläche der Leiterplatte bewegt werden können. Erst beim Erreichen der Oberfläche der Leiterplatte, oder kurz vorher, werden diese zum Kontaktieren eines Leiterplatten-Testpunktes abgebremst. Dieses Dokument zeigt eine Prüfvorrichtung zum Testen von unbestückten Leiterplatten mit zwei Traversen, wobei ein jeder Prüfkopf an einen Förderriemen gekoppelt ist, mit welchem er automatisch entlang der jeweiligen Traverse verfahrbar ist.

Die DE 10 2006 006255 A1 betrifft ein Verfahren zum Prüfen unbestückter Leiterplatten mit einem Fingertester. Bei diesem Fingertester sind die optischen Detektionseinrichtungen von der jeweiligen Messstelle bzw. der Oberfläche einer zu untersuchenden Leiterplatte unterschiedlich weit beabstandet bzw. bezüglich der Höhe in unterschiedlichen Ebenen angeordnet. Der Abstand ist dabei so gewählt, dass die unterschiedlichen Ebenen so weit auseinander liegen, dass selbst bei sehr eng aneinander gefahrenen Schlitten bzw. Prüfsonden die jeweiligen Lichtlenkeinheiten übereinander angeordnet werden können, ohne miteinander zu kollidieren. Aus diesem Dokument geht hervor, dass es bei Fingertestern üblich ist, zwei oder mehrere Prüffinger pro Traverse vorzusehen.

Die DE 10 2006 005800 A1 beschreibt ein Verfahren und eine Vorrichtung zum Testen von unbestückten Leiterplatten beschreibt. Mit dem darin beschriebenen Verfahren werden Abweichungen von den CAD-Daten vor dem eigentlichen Durchführen eines Testvorgangs ermittelt. Beim Testen der Leiterplatte mit einem Fingertester werden die Prüffinger nach Maßgabe der ermittelten Abweichung angesteuert. Mit dem Verfahren werden Fehlkontaktierungen, sowie das Eintauchen einer Prüfnadel in eine Kontaktierung, die zu einer Beschädigung der Prüfnadel führen kann, vermieden. Dieses Dokument zeigt eine Vorrichtung zum Prüfen von Leiterplatten, die als Fingertester ausgebildet ist. Oberhalb und unterhalb eines Aufnahmebereichs der Vorrichtung zum Aufnehmen von Leiterplatten sind Traversen angeordnet. Die Traversen werden mit ihren Enden in Schienen gehalten, wobei an den Traversen jeweils zwei Schlitten angeordnet sind, die entlang der Traversen hin und her verfahrbar sind.
Der Erfindung liegt die Aufgabe zugrunde, die Nachteile im Stand der Technik wenigstens teilweise zu vermeiden. Insbesondere ist eine Aufgabe der Erfindung, den Justierungs- und Kalibrierungsaufwand in einer Prüfvorrichtung zum Testen von Leiterplatten mittels Testfingern zu verringern. Eine weitere Aufgabe der Erfindung besteht darin, eine Anpassung einer solchen Prüfvorrichtung an geänderte Prozessbedingungen rasch und effizient vornehmen zu können.

Die vorstehend genannte Aufgabe wird wenigstens in Teilaspekten durch die Merkmale des unabhängigen Anspruchs 1 gelöst. Bevorzugte Ausführungsformen und vorteilhafte Weiterbildungen der Erfindung sind in den Unteransprüchen angegeben.
Nach einem Gesichtspunkt der vorliegenden Erfindung wird eine neuartige Traverseneinheit für eine Prüfvorrichtung für Leiterplatten vorgeschlagen. Die Traverseneinheit weist wenigstens eine ein Prüffeld, in dem eine zu prüfende Leiterplatte angeordnet werden kann, überspannende Traverse auf und ist ausgebildet, um Positioniereinheiten für Testfinger in einer linear verfahrbaren Weise derart aufzunehmen, dass die Testfinger zumindest einen Teil des Prüffelds abtasten können. Ferner ist die Traverseneinheit ausgebildet, wenigstens zwei voneinander unabhängige Linearführungen zum Führen von jeweils wenigstens einer der Positioniereinheiten aufzunehmen.
Mit anderen Worten, die Prüfvorrichtung ist eine Vorrichtung zum Testen von unbestückten oder bestückten Leiterplatten, wobei die Leiterplatten in einem Prüffeld angeordnet werden und Prüffinger die einzelnen Kontaktstellen sequenziell abtasten. Unter einer Traverseneinheit wird im Sinne der Erfindung eine einstückige oder verbundene, aber jedenfalls eine feste Einheit bildende Raumform verstanden, die wenigstens eine das Prüffeld überspannende Traverse aufweist. Eine feste Einheit bildende Raumform ist somit eine steife, stabile bauliche Einheit, die mehrteilig und vorzugsweise einteilig ausgebildet ist. Demzufolge kann die Traverseneinheit eine einzige Traverse aufweisen bzw. durch eine einzige Traverse gebildet werden oder mehrere Traversen aufweisen, die zu einer festen baulichen Einheit zusammengefasst sind. Im Sinne der Erfindung ist die Traverseneinheit zu unterscheiden von einem raumfesten Gestell der Prüfvorrichtung, in denen die Traverseneinheit gelagert ist. Eine Linearführung ist im Sinne der Erfindung eine Führung, z. B. Schiene, zum linearen Führen der Positioniereinheiten, insbesondere auf gerader Linie. Ein Verfahrantrieb kann in die Linearführung integriert, aber auch separat vorgesehen sein. Unter einer Unabhängigkeit der Linearführungen wird im Sinne der Erfindung verstanden, dass Positioniereinheiten unterschiedlicher Linearführungen sich beim Verfahren nicht ins Gehege kommen können. Insbesondere sind die Linearführungen parallel beabstandet. Wenn nur eine kapazitive Abtastung der Prüfpunkte auf der Leiterplatte erfolgt, kann eine Positioniereinheit (für einen Testfinger) je Linearführung ausreichen. Da oft auch eine resistive Abtastung vorgenommen wird, sind zwei Positioniereinheiten mit Testfinger je Linearführung bevorzugt. Es sind auch mehr Positioniereinheiten je Linearführung möglich.

Gemäß diesem Gesichtspunkt der vorliegenden Erfindung können an einer einzigen Traverseneinheit mindestens zwei Gruppen von Positioniereinheiten verfahren werden, ohne dass sich die Verfahrwege der zwei Gruppen gegenseitig beeinflussen (wobei eine Gruppe eine oder mehrere Positioniereinheiten umfassen kann). Da die Linearführungen an einem einzigen Bauteil angebracht sind, ist die Ausrichtung der Linearführungen zueinander exakt definiert und unveränderlich. Demzufolge ist ein Aufwand für Justage und Kalibrierung geringerer. Die erfindungsgemäße Traverseneinheit kann fest an einem Gestell der Prüfvorrichtung montiert oder ihrerseits verfahrbar gelagert sein. Gegenüber einer verfahrbaren Traverse mit nur einer Linearführung sind bei der erfindungsgemäßen Traverseneinheit wenigstens zwei Linearführungen in ihrer relativen Lage unveränderlich, sodass sich ein Aufwand für Justage und Kalibrierung zumindest halbiert. Je mehr Linearführungen an der Traverseneinheit vorgesehen sind, desto deutlicher macht sich dieser Vorteil bemerkbar.

In einer bevorzugten Ausführungsform sind die Linearführungen seitlich an jeweiligen Traversen vorgesehen. Als seitlich wird dabei eine Richtung quer zur Längsrichtung der Traverse, parallel zur Prüffeldebene verstanden. Bei seitlicher Anordnung sind die Positioniereinheiten in der Prüfvorrichtung wesentlich besser zugänglich.

In einer bevorzugten Ausführungsform weist wenigstens eine der Traversen zwei der Linearführungen auf, wobei die zwei Linearführungen parallel zueinander verlaufen. Diese Anordnung hat auch den Vorteil, dass Paare von Prüfpunkten, die quer zur Traversenrichtung voneinander beabstandet sind, im Rahmen der Reichweite der Testfinger mit einer einzigen Traverse getestet werden können, ohne dass eine Position der Traverse geändert werden muss. Die zwei Linearführungen sind auf einer einzigen Traverse angeordnet, sodass ihre Relativlage zueinander exakt definiert und unveränderlich ist. Die Traverseneinheit kann eine oder mehr solcher Traversen mit zwei Linearführungen aufweisen.

In einer bevorzugten Ausführungsform weist die Traverseneinheit wenigstens zwei das Prüffeld überspannende Traversen auf, wobei jede der wenigstens zwei Traversen wenigstens eine der Linearführungen aufweist, wobei die wenigstens zwei Traversen vorzugsweise parallel zueinander verlaufen. Bei dieser Ausführungsform sind die zwei Linearführungen auf einer einzigen Traverseneinheit, also einem zusammengehörigen Bauteil, angeordnet, sodass ihre Relativlage zueinander exakt definiert und unveränderlich ist. In Kombination mit der vorherigen Ausführungsform kann die Traverseneinheit mit zwei Traversen bereits vier Linearführungen und damit vier voneinander unabhängig verfahrbare Testfingergruppen aufweisen. Zwei oder mehr Traversen können als Module vorbereitet werden und auf einfache Weise miteinander zu einer festen Raumform verbunden werden. Dies vereinfacht die Fertigung unterschiedlicher Prüfvorrichtungen wesentlich, da die Traverseneinheiten mit mehreren Linearführungen als Module einsetzbar sind, wobei alle Positioniereinheiten bereits zueinander exakt ausgerichtet sind. Wenn Traversen der Traverseneinheit so verbunden sind, dass sie nebeneinander (also auf der gleichen Seite des Prüffeldes) zu liegen kommen, ist es von Vorteil, den Abstand der Traversen so vorzusehen, dass auch alle Punkte zwischen den Traversen von Testfingern erreicht werden können. So können auch in diesem Fall Paare von Prüfpunkten, die quer zur Traversenachse voneinander beabstandet sind, im Rahmen der Reichweite der Testfinger getestet werden, ohne dass eine Position der Traverseneinheit geändert werden muss.

In einer bevorzugten Ausführungsform verläuft von den wenigstens zwei Traversen wenigstens eine auf einer Seite einer Prüffeldebene des Prüffeldes und wenigstens eine auf einer anderen Seite der Prüffeldebene. Das Prüffeld, in dem die Leiterplatten aufgenommen werden können, weist eine Hauptebene auf, innerhalb der sich die Leiterplatte erstreckt. Diese Hauptebene wird auch als Prüffeldebene bezeichnet. In dieser Ausführungsform sind die Führungen diesseits und jenseits des Prüffeldes auf einer einzigen Traverseneinheit, also einem integralen Bauteil, angeordnet, sodass ihre Relativlage zueinander exakt definiert und unveränderlich ist. Jede der zwei Traversen kann eine oder zwei Linearführungen aufweisen. Wenn beispielsweise eine zu prüfende Leiterplatte grundsätzlich auf einer Seite deutlich mehr Prüfpunkte aufweist als auf der anderen Seite, kann diejenige Traverse, die die Seite mit der größeren Menge an Prüfpunkten überspannt, zwei Linearführungen aufweisen, während die Traverse auf der anderen Seite nur eine Linearführung aufweist.

In einer bevorzugten Ausführungsform sind die wenigstens zwei Traversen genau zwei Traversen, die durch Verbindungsstücke zu einer Ringform von wenigstens im Wesentlichen rechteckigem Verlauf, vorzugsweise einstückig, verbunden sind, so dass die Traverseneinheit das Prüffeld derart umspannt, dass das Prüffeld zwischen den zwei Traversen angeordnet ist. Mit anderen Worten, die Traverseneinheit bildet einen rechteckförmigen Rahmen mit zwei Traversen, die das Prüffeld diesseits und jenseits (auf einer Vorder- und einer Rückseite der zu prüfenden Leiterplatten) überspannen. Somit bilden die Traversen mit den Verbindungsstücken eine bauliche Einheit, die das Prüffeld umschließt. Durch Kombination der Ausführungsformen können mit dieser rahmenförmigen Traverseneinheit vier Linearführungen mit vier Gruppen von Testfingern (je zwei diesseits und zwei jenseits der Prüffeldebene) zu einem Testmodul zusammengefasst werden, wobei die Relativlage der Linearführungen untereinander exakt definiert und unveränderlich ist. Die Ringform kann beispielsweise einstückig gegossen oder aus einer Platte ausgeschnitten werden. Als Verbundteil kann die Ringform auch durch ein Schweißteil von aneinandergeschweißten Platten oder Profilen hergestellt werden. Definierte Anschlusspunkte und -ebenen für die Linearführungen, für Antriebe, Mess- und Steuergeräte, Kabelführungen, etc. und zum Anschluss an das Gestell können durch an sich bekannte Maßnahmen der Nachbearbeitung ausgebildet werden. Eine Rechteckringform ist vergleichsweise einfach herstellbar und für Lagerung, Transport und Montage gut handhabbar.

In einer vorteilhaften Weiterbildung ist die Traverseneinheit vorbereitet, um an vorgegebenen Anschlusspunkten eines Gestells der Prüfvorrichtung fest montiert zu werden. Die Position der Traverseneinheit relativ zu dem Gestell ist dadurch exakt definiert und unveränderlich. Somit sind je nach Kombination der Ausführungsformen bereits zwei bis vier oder mehr Linearführungen in ihrer Lage in der Prüfvorrichtung exakt und unveränderlich definiert. Grundsätzlich ist es natürlich auch möglich, dass die Traverseneinheit selbst verfahrbar am Gestell gelagert ist. Die Vorteile der Erfindung werden zumindest teilweise auch dann erreicht.

In einer bevorzugten Ausführungsform weisen die Positioniereinheiten jeweils eine Schwenkeinheit und eine Verfahreinheit auf, wobei die Testfinger jeweils einen mit der Schwenkeinheit einer zugehörigen Positioniereinheit verbundenen Schwenkarm und eine am Schwenkarm befestigte Prüfsonde aufweisen, wobei die Verfahreinheit jeweils in einer der Linearführungen gelagert und durch eine Antriebseinrichtung verfahrbar ist, und wobei die Linearführungen an der Traverseneinheit befestigt sind. Die Schwenkarmanlenkung ermöglicht eine Positionierung der Testfinger quer zur Linearführung ohne Versetzen bzw. Verfahren der Traverseneinheit selbst. Das erleichtert es, die Traverseneinheit fest an einem Gestell anzubringen, wobei gegebenenfalls mehrere Traverseneinheiten erforderlich sind, um die Länge des Prüffeldes abzudecken. Aber auch bei einer verfahrbaren Traverseneinheit ist die Positionierung durch den Schwenkarm wegen der geringeren zu bewegenden Massen schneller, belastungsärmer und energieeffizienter als ein Verfahren der ganzen Traverseneinheit. Soweit zwei Linearführungen an einer Traverse vorgesehen sind, ermöglichen die Schwenkarme, den Bereich des Prüffeldes zwischen den Positioniereinheiten zu erreichen. Die Antriebseinrichtung kann wenigstens teilweise als Teil der Positioniereinheit ausgebildet sein (etwa als Läufer eines Linearantriebs oder als Ritzel, wobei ein zugehöriger Stator bzw. eine Zahnschiene an der Traverseneinheit befestigt ist), oder separat an der Traverseneinheit befestigt sein (etwa in Form eines Kolbens oder eines Seilzugs). Die Schwenkeinheit kann einen Schrittmotor oder einen rotatorischen Linearmotor (Linearmotor mit gekrümmtem Bewegungsverlauf) aufweisen. Neben einer Schwenkeinheit zur Verwirklichung von Positionierungen koplanar mit der Prüffeldebene kann auch eine Hubeinheit zum Verwirklichen einer Positionierung senkrecht zur Prüffeldebene vorgesehen sein. Die Hubeinheit kann beispielsweise einen Linearmotor aufweisen. Die Hubeinheit und die Schwenkeinheit können in einer Hub-Schwenk-Einheit baulich zusammengefasst sein. Aus Gewichtsgründen können die Schwenkarme vorzugsweise als Carbonfaserbauteil ausgebildet sein.

In einer vorteilhaften Weiterbildung ist ein Achsabstand der Schwenkachse der Schwenkeinheit einer Positioniereinheit von der jeweiligen Linearführung und/oder ein Sondenabstand einer Prüfsonde von der Schwenkachse der Schwenkeinheit einer jeweiligen Positioniereinheit veränderbar, wobei der Achsabstand bzw. der Sondenabstand vorzugsweise in vorgegebenen Stufen veränderbar ist. Eine Variierung der Abstände erlaubt eine Anpassung der Lage der Schwenkachse an jeweilige Prozess- bzw. Prüfbedingungen. Es ist beispielsweise möglich, bei einem großen Sondenabstand eine große Fläche mit einer einzigen Traverseneinheit abzutasten, während bei einem kleinen Sondenabstand die Positioniergeschwindigkeit und - genauigkeit erhöht werden kann. Um die Abtastgeschwindigkeit insgesamt und damit auch den Durchsatz zu prüfender Leiterplatten zu erhöhen, können mehrere Traverseneinheiten (Module) gleichen Typs hinzugenommen werden, wobei ein kleiner Sondenabstand gewählt werden kann. Wenn zwei Linearführungen an einer Traverse vorgesehen sind, insbesondere jeweils seitlich an gegenüberliegenden Seiten der Traverse, ist es vorteilhaft, neben dem Sondenabstand gleichzeitig auch den Achsabstand zu ändern, um den Bereich zwischen den Schwenkachsen optimal abtasten zu können. Um die Abtastgeschwindigkeit und damit auch den Durchsatz zu prüfender Leiterplatten zu erhöhen, kann eine zweite Traverseneinheit gleichen Typs hinzugenommen werden, wobei die Achsabstände und Sondenabstände verringert werden. Die Prüfvorrichtung kann daher je nach Leistungsbedarf aufgerüstet werden, indem ein zweites Modul hinzugenommen und von dem ersten (alten) Modul nur die Abstände geändert werden.

In einer bevorzugten Ausführungsform sind Verbindungsflächen zweier baulicher Bestandteile der Positioniereinheit als eine Schnittstelle zur Veränderung des Achsabstands ausgebildet, wobei vorzugsweise Distanzstücke vorgegebener Stärke zur Veränderung des Achsabstands zwischen den Verbindungsflächen anbringbar sind. Mit diesem Aufbau ist die die Variierbarkeit des Achsabstands auf eine einfache Weise konstruktiv umsetzbar, da solche Verbindungsflächen ohnehin oft vorgesehen sind. Die Schnittstelle kann beispielsweise zwischen der Schwenkeinheit und der Verfahreinheit vorgesehen sein. Es ist auch möglich, die Schnittstelle zwischen der Schwenkeinheit und einer Hubeinheit oder zwischen einer Hubeinheit und der Verfahreinheit vorzusehen, je nach baulicher Reihung der Einheiten. Eine besonders einfache Lösung kann dadurch verwirklicht werden, dass die Verbindungsflächen parallel zur Verfahrrichtung und senkrecht zur Prüfebene liegen und wahlweise direkt miteinander verschraubt werden oder mit einem dazwischen anzuordnenden Distanzstück verschraubt werden können. In einer Variante kann die Schnittstelle durch parallel zu der Prüffeldfläche liegende Verbindungsflächen verwirklicht werden, wobei die Verbindungsflächen durch wahlweise nutzbare Anschraubpunkte oder dergleichen mit unterschiedlichem Abstand von der Verfahreinheit verbunden werden können. Im letzteren Fall können an den Verbindungsflächen Rasteinrichtungen vorgesehen sein, welche die einstellbaren Abstände in vorgegebenen Stufen eindeutig festlegen.

Zur Veränderung des Sondenabstands können Schwenkarme unterschiedlicher Längen vorgesehen sein, die zwischen der Schwenkachse und der Prüfsonde montierbar sind. Dies ermöglicht eine konstruktiv einfache und in der Anwendung wenig aufwändige Variierung des Sondenabstands. Dabei ist besonders vorteilhaft, wenn der Sondenabstand an den jeweiligen Achsabstand anpassbar ist, wobei insbesondere Distanzstücke zur Festlegung des Achsabstands und Schwenkarme zur Festlegung des Sondenabstands mit aneinander angepassten Distanzstück-Stärken bzw. Schwenkarm-Längen vorgesehen sind. Wenn der Abstand der Schwenkachse von der Linearführung veränderbar ist, ist es auch möglich, durch Einsatz von Schwenkarmen mit angepasster Länge die Reichweite der Testfinger zu verändern. Es ist also möglich, bei Einsatz von langen Schwenkarmen und Distanzstücken eine große Fläche mit einer einzigen Traverseneinheit abzutasten. Um die Abtastgeschwindigkeit und damit auch den Durchsatz zu prüfender Leiterplatten zu erhöhen, kann eine zweite Traverseneinheit gleichen Typs hinzugenommen werden, wobei die Abstände der Schwenkachsen durch Entfernen oder Austauschen der Distanzstücke verringert und die langen Schwenkarme durch kurze Schwenkarme ersetzt werden. Die Prüfvorrichtung kann daher je nach Leistungsbedarf aufgerüstet werden, indem ein zweites Modul hinzugenommen und von dem ersten (alten) Modul nur die Abstände und die Schwenkarme geändert werden. Andererseits können aus einer Prüfvorrichtung mit mehreren Traverseneinheiten, kleinen Achs- und Sondenabständen und dementsprechend hohem Durchsatz mit vergleichsweise geringem Aufwand zwei oder mehr Prüfvorrichtungen mit entsprechend geringerem Durchsatz gemacht werden, indem ein zweites (oder drittes, usw.) Gestell mit jeweiliger Leiterplattenzuführung bereitgestellt wird und eine oder mehrere Traverseneinheiten aus der einen Prüfvorrichtung in die neuen Gestelle eingebaut werden und die Abstände durch Einbau von entsprechenden Distanzstücken und Schwenkarmen vergrößert werden. Derartige Anordnungen erlauben also die Herstellung unterschiedlicher Prüfvorrichtungen - mit wenigen oder vielen Traversen mit unterschiedlichem Abstand zwischen den Traverseneinheiten mit im wesentlichen gleichen Bauteilen, wobei nur die Distanzstücke und die Schwenkarme als aneinander angepasster Bauteilsatz ausgetauscht werden müssen. Hierdurch können auch erhebliche Einsparung in der Fertigung bei dennoch hoher Präzision erzielt werden.

Nach einem weiteren Gesichtspunkt der Erfindung wird eine Prüfvorrichtung für Leiterplatten mittels Testfingern vorgeschlagen, wobei die Testfinger so gelagert und verfahrbar sind, dass ein Prüffeld, in dem eine zu prüfende Leiterplatte angeordnet werden kann, durch die Testfinger abgetastet werden kann. Erfindungsgemäß weist die Prüfvorrichtung wenigstens eine Traverseneinheit gemäß einem der vorstehenden Ansprüche auf.

Mit anderen Worten, bereits mit einer Traverseneinheit mit zwei Traversen kann eine Prüfvorrichtung mit bis zu vier Testfingergruppen verwirklicht werden. Die eine Traverseneinheit kann alle benötigten Testfinger tragen. Je nach Größe des Prüffeldes können mehrere Traverseneinheiten verwendet werden.

In einer bevorzugten Ausführungsform weist die Prüfvorrichtung ein ortsfestes Gestell auf, wobei das Gestell eine Mehrzahl von Anschlusspunkten aufweist, die eine Befestigung der wenigstens einen Traverseneinheit an unterschiedlichen Positionen relativ zu dem Prüffeld ermöglicht. Die Position(en) der Traverseneinheit(en) relativ zu dem Gestell sind dadurch exakt definiert und unveränderlich. Mehrere Traverseneinheiten können als Module mit jeweils zwei, drei, vier oder mehr Testfingergruppen in unterschiedlichen Abständen auf dem Gestell montiert werden. Die Abstände können je nach Länge der Schwenkarme der Testfinger gewählt werden. Auf diese Weise kann die Prüfvorrichtung beliebig dimensioniert und skaliert werden. Die Linearführungen werden allein durch das Gestell und die Traverseneinheit(en) exakt ausgerichtet. Wenn die Traversenanordnung ein Rechteckrahmen mit zwei beidseits des Prüffeldes verlaufenden Traversen ist, kann das Gestell beispielsweise auf einfache Weise durch zwei ortsfeste Bodenbalken mit definiertem Abstand verwirklicht werden, auf welchem die Traverseneinheit(en) ausgerichtet und befestigt wird bzw. werden. Zur exakten und zuverlässigen Ausrichtung ist es vorteilhaft, wenn die Balken und die Traverseneinheit(en) entsprechend steif ausgebildet und starr zueinander ausrichtbar sind.

Die Erfindung wird nachstehend anhand der beigefügten Zeichnungen genauer erläutert. Dabei zeigt
- Fig. 1: eine räumliche Darstellung einer Prüfvorrichtung für Leiterplatten mit Prüffingern (sog. Fingertester) als ein Ausführungsbeispiel der vorliegenden Erfindung;
- Fig. 2: eine Frontalansicht der Prüfvorrichtung von Fig. 1;
- Fig. 3: eine Querschnittsansicht der Prüfvorrichtung entlang einer Linie "III" in Fig. 2;
- Fig. 4: eine Ansicht entsprechend Fig. 3 einer zweiten Montierungsart der Prüfvorrichtung;
- Fig. 5: einen durch eine Linie "V" in Fig. 4 gekennzeichneten Ausschnitt in einer vergrößerten Darstellung;
- Fig. 6: einen durch eine Linie "VI" in Fig. 5 gekennzeichneten Ausschnitt in einer weiter vergrößerten Darstellung;
- Fig. 7: eine Ansicht in Richtung eines Pfeils "VII" in Fig. 6;
- Fig. 8: einen durch eine Linie "VIII" in Fig. 4 gekennzeichneten Ausschnitt in einer vergrößerten Darstellung;
- Fig. 9: einen durch eine Linie "IX" in Fig. 8 gekennzeichneten Ausschnitt in einer weiter vergrößerten Darstellung; und
- Fig. 10: eine Ansicht in Richtung eines Pfeils "X" in Fig. 9.

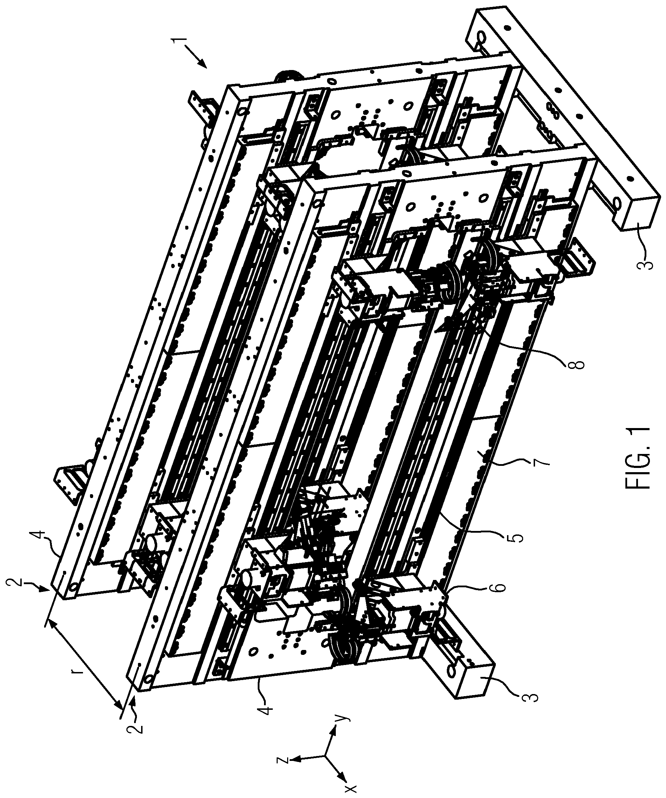

Fig. 1 zeigt eine Prüfvorrichtung 1 mit Prüffingern (sog. Fingertester) zum Testen von Leiterplatten als ein Ausführungsbeispiel der vorliegenden Erfindung in einer räumlichen Darstellung.

Gemäß der Darstellung in Fig. 1 weist die Prüfvorrichtung zwei Traverseneinheiten 2 auf, die auf zwei Bodenbalken 3 gelagert sind. Im Sinne der Erfindung bilden die Bodenbalken 3 ein Gestell. Jede Traverseneinheit 2 wird durch einen Rahmen 4 mit daran angeordneten Anbauteilen gebildet. Der Rahmen 4 wird später genauer beschrieben werden. Jeder der Rahmen 4 trägt mehrere Linearführungen (Schienen) 5, an denen jeweils zwei Positioniereinheiten 6 verfahrbar gelagert sind. Die Positioniereinheiten 6 sind jeweils durch eine Statoreinheit 7 antreibbar und tragen jeweils einen Prüffinger 8.

Zur weiteren Orientierung ist ein kartesisches Koordinatensystem mit Raumrichtungen x, y, z angegeben, wobei ohne Beschränkung der Allgemeinheit die Raumrichtung x als Längsrichtung x, die Raumrichtung y als Querrichtung und die Raumrichtung z als Hochrichtung bezeichnet wird. Die Längsrichtung x kann auch als Laderichtung x bezeichnet werden, da zu prüfende Leiterplatten in dieser Richtung x in die Prüfvorrichtung 1 geladen (und entladen) werden. Die Laderichtung x entspricht einer Erstreckungsrichtung der Bodenbalken 3, und eine Hauptebene der Rahmen 4 schließt die y- und die z-Raumrichtung ein.

Obschon in dieser Figur nicht näher dargestellt, sind die Bodenbalken 3 an einem Boden einer Werkhalle oder dergleichen raumfest, und sind die Rahmen 4 fest an beiden Bodenbalken 3 verschraubt. Die Bodenbalken 3 können daher auch als Gestell für die Rahmen 4 bezeichnet werden. Die Rahmen 4 weisen einen Rahmenabstand r in x-Richtung voneinander auf.

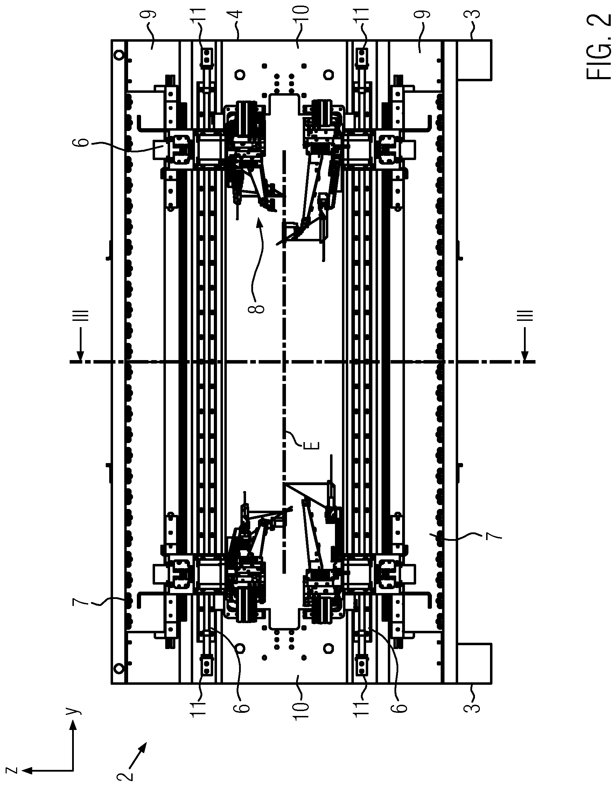

Fig. 2 zeigt die Prüfvorrichtung 1 aus der Raumrichtung x, also in einer Frontalsicht.

Gemäß der Darstellung in Fig. 2 ist der Rahmen 4 ein einstückiges Bauteil, das in zwei parallele Traversen 9 und zwei die Traversen 9 endseitig verbindende Holme 10 gegliedert werden kann. Ohne Beschränkung der Allgemeinheit erstrecken sich die Traversen 9 in der Querrichtung y und erstrecken sich die Holme 10 in der Hochrichtung z der Prüfvorrichtung 1. Die in Fig. 2 gezeigte Seite des Rahmens 4 wird ohne Beschränkung der Allgemeinheit als Vorderseite, die in der Figur verdeckte Seite als Rückseite des Rahmens 4 bezeichnet. Der Rahmen 4 ist in der hier gezeigten und beschriebenen Ausführungsform durch eine einzige Stahlplatte hergestellt, aus der beispielsweise durch Schneidbrennen oder dergleichen ein Fenster ausgeschnitten wurde. Alternativ kann der Rahmen 4 auch als Gußteil oder als Schweißteil hergestellt werden.

Die Traversen 9 und Holme 10 umschließen eine Prüfebene E. Die Prüfebene E gibt eine Lage von Leiterplatten (nicht näher dargestellt) wieder, die in der Prüfvorrichtung 1 geprüft werden können, schließt die Raumrichtungen x und y ein und weist von den Traversen 9 in etwa den gleichen Abstand auf.

Jede der Traversen 9 trägt auf der in Fig. 2 gezeigte Vorderseite eine Linearführung 5 und eine Statoreinheit 7. Die als eine Schiene ausgebildete Linearführung 5 erstreckt sich parallel mit der Statoreinheit 7 in der Querrichtung y und liegt näher an der Prüfebene E als die Statoreinheit 7. Wie bereits erwähnt, sind an jeder Linearführung 5 zwei Positioniereinheiten 6 verschiebbar gelagert und trägt jede Positioniereinheit einen Prüffinger 8. Endanschläge 11 begrenzen den Bewegungsraum der Positioniereinheiten 6 auf den Linearführungen 5. Die jeweiligen Prüffinger 8 weisen jeweils zu der Prüfebene E und sind in der zugehörigen Positioniereinheit 6 heb- und schwenkbar gelagert. Mit anderen Worten, die Prüffinger 8, die an der oberen der Traversen 9 geführt sind, weisen nach unten (negative z-Richtung), und die Prüffinger 8, die an der unteren der Traversen 9 geführt sind, weisen nach oben (positive z-Richtung).

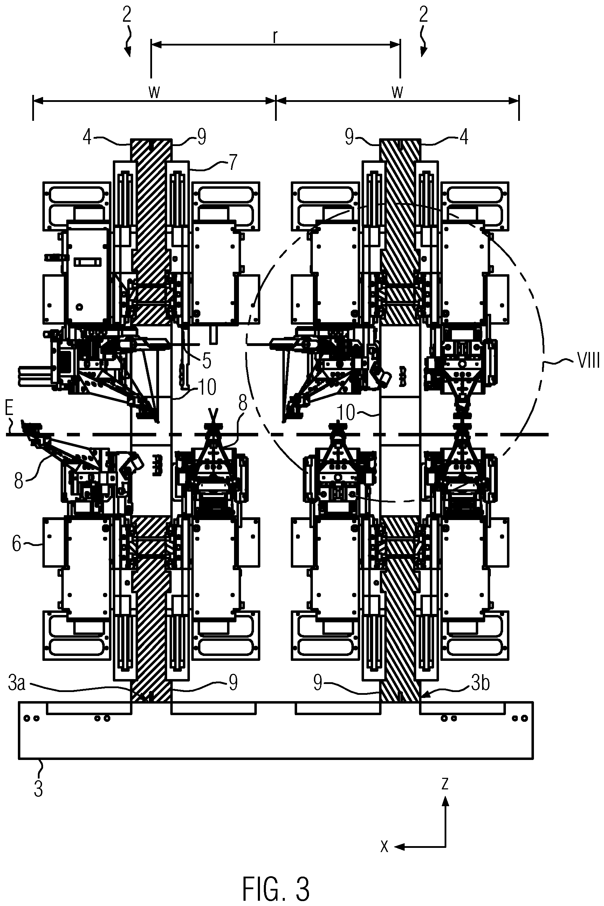

Fig. 3 zeigt einen Querschnitt durch die Prüfvorrichtung 1 entlang einer Linie III-III in Fig. 2 in Richtung der dort angegebenen Pfeile.

In der Schnittansicht in Fig. 3 ist erkennbar, dass die Traversen 9 der Rahmen 4 auf Vorder- und Rückseite identisch mit Linearführungen 5, Statoreinheiten 7, Positioniereinheiten 6 und Prüffingern 8 ausgerüstet sind. Die Prüffinger 8 sind an den Positioniereinheiten 6 schwenkbar gelagert und können in x-Richtung sowohl einen Bereich zwischen den Positioniereinheiten 6 als auch einen Bereich jenseits der Positioniereinheiten erreichen. Zusammen decken die Prüffinger 8 auf Vorder- und Rückseite der Rahmen 4 eine Abtastbreite w ab. Der Rahmenabstand r zwischen den Rahmen 4 ist so gewählt, dass die Abtastbereiche der jeweiligen Prüffinger 8 einander in x-Richtung gerade erreichen.

Wie in Fig. 3 ferner gezeigt, ruhen die Rahmen 4 mit den unteren ihrer Traversen 9 auf Auflageflächen 3a, 3b, die im Rahmenabstand r auf der Oberseite der Bodenbalken 3 vorgesehen sind. Die Lage der Auflageflächen 3a, 3b ist exakt vorgegeben, und durch nicht näher dargestellte Mittel sind die Rahmen 4 auf den Auflageflächen 3a, 3b exakt ausgerichtet (zentriert) und fest, aber lösbar, mit den Bodenbalken 3 verbunden (etwa verschraubt).

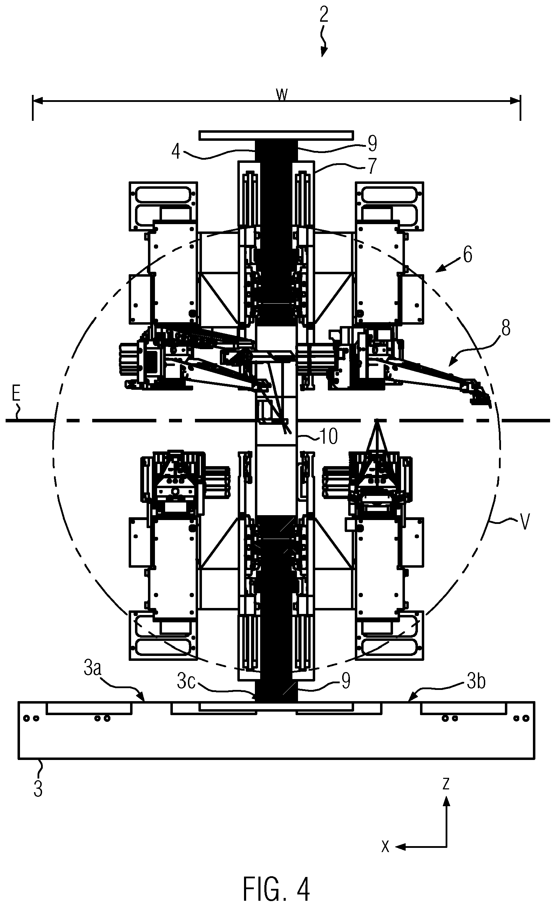

Fig. 4 zeigt einen Querschnitt durch die Prüfvorrichtung 1 in einer Ansicht entsprechend Fig. 3. In Fig. 4 ist eine zweite Montageart gezeigt, die sich von der in Fig. 3 gezeigten (ersten) Montageart unterscheidet.

Gemäß Fig. 4 sind bei dieser Montageart nicht zwei Traverseneinheiten, sondern nur eine Traverseneinheit 2 vorgesehen. Die Traverseneinheit 2 ist wie zuvor aus einem Rahmen 4 mit weiteren Anbauteilen 5, 6, 7, 8, etc. gebildet, wobei der Rahmen 4 einstückig aus zwei Traversen 9 und zwei Verbindungsstücken bzw. Holmen 10 aufgebaut ist.

In der Schnittansicht in Fig. 4 ist erkennbar, dass die Traversen 9 der Rahmen 4 auf Vorder- und Rückseite identisch mit Linearführungen 5, Statoreinheiten 7, Positioniereinheiten 6 und Prüffingern 8 ausgerüstet sind. Die Prüffinger 8 sind an den Positioniereinheiten 6 schwenkbar gelagert und können in x-Richtung sowohl einen Bereich zwischen den Positioniereinheiten 6 als auch einen Bereich jenseits der Positioniereinheiten 6 erreichen. Zusammen decken die Prüffinger 8 der Traverseneinheit 2 auf Vorder- und Rückseite der Rahmen 4 eine Abtastbreite w ab. Durch eine nachstehend genauer beschriebene Abwandlung der Positioniereinheit 6 und der Prüffinger 8 wird erreicht, dass die Abtastbreite w der Prüffinger 8 bei dieser Traverseneinheit 2 größer ist als bei den zwei Traverseneinheiten der vorherigen Montageart.

Wie in Fig. 3 ferner gezeigt, ruht der Rahmen 4 mit der unteren seiner Traversen 9 auf einer Auflagefläche 3c, die zwischen den zuvor beschriebenen Auflageflächen 3a, 3b vorgesehen ist. Die Lage der Auflageflächen 3a, 3b, 3c zueinander ist exakt vorgegeben, und durch nicht näher dargestellte Mittel ist der Rahmen 4 auf der Auflagefläche 3c exakt ausgerichtet (zentriert) und fest, aber lösbar, mit den Bodenbalken 3 verbunden (etwa verschraubt).

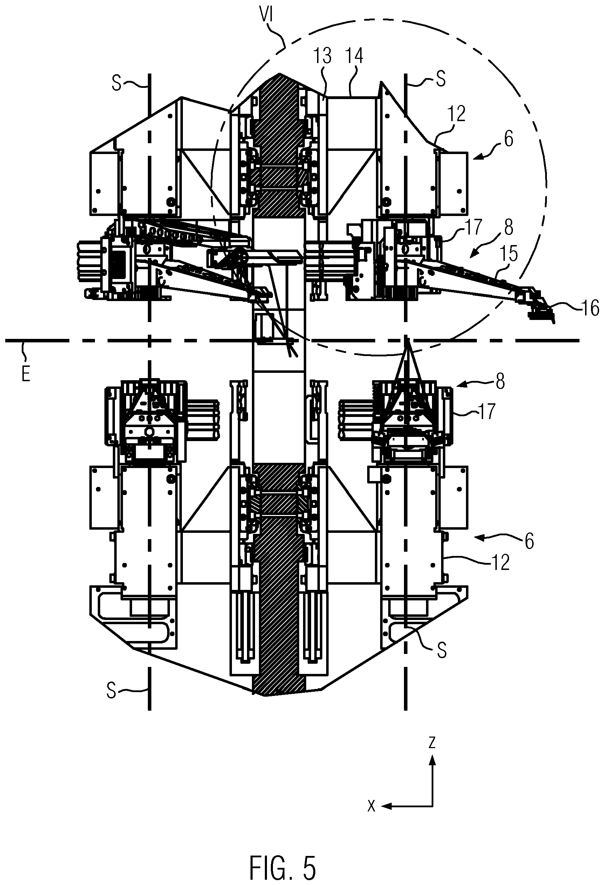

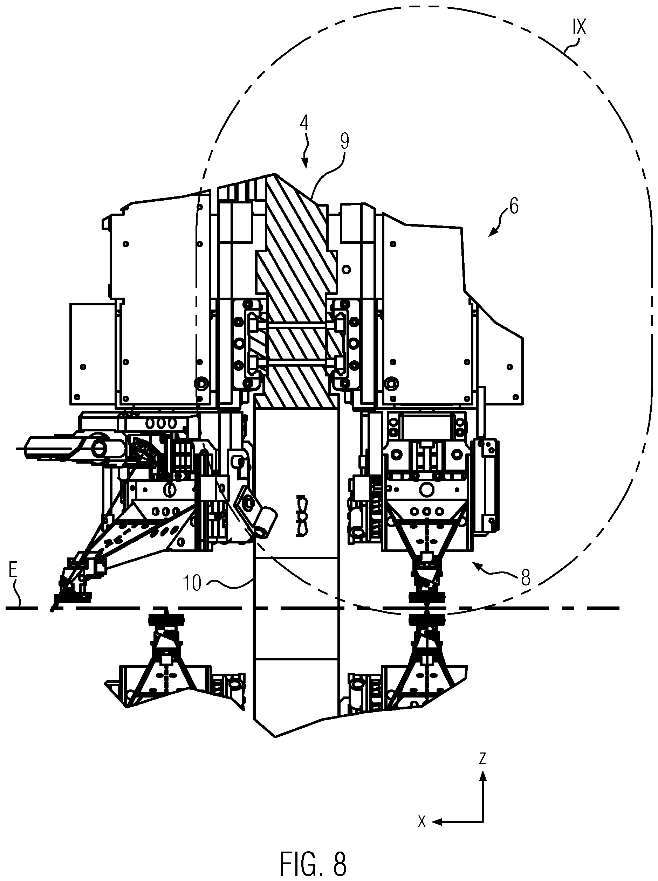

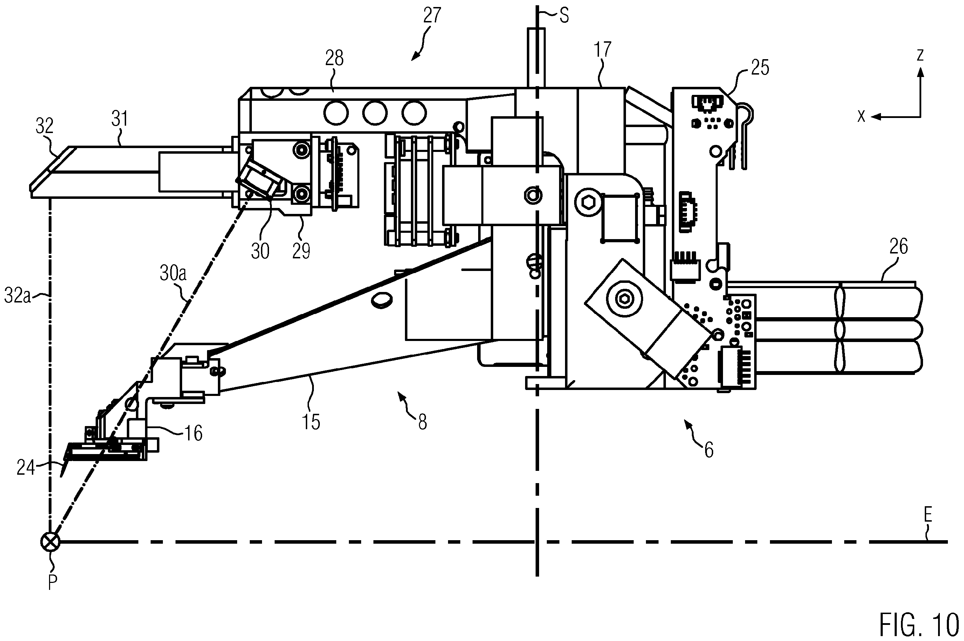

Nachstehend wird zunächst die zweite Montageart gemäß Fig. 4 anhand der Fign. 5 bis 7 weiter beschrieben werden, während später anhand der Fign. 8 bis 10 auf die erste Montageart gemäß Fign. 1 bis 3 zurückgekommen werden wird.

Fig. 5 zeigt einen Ausschnitt, der in Fig. 4 durch eine strichpunktierte Linie "V" angegeben ist, in einer vergrößerten Ansicht. Es ist anzumerken, dass Schwenkstellungen jeweiliger Prüffinger 8 sich von denjenigen in Fig. 4 unterscheiden können.

Wie in Fig. 5 gezeigt, weist die Positioniereinheit 6 eine Schwenkeinheit 12 mit einer Schwenkachse S auf. Die Schwenkeinheit 12 weist einen Schwenkantrieb mit einer Abtriebswelle (hier nicht näher dargestellt) auf, die eine Schwenkachse S aufweist. Die Positioniereinheit 6 weist ferner eine Verfahreinheit 13 auf, die an der Linearführung 5 gelagert ist. Die Schwenkeinheit 12 ist über ein Distanzstück 14 an der Verfahreinheit 13 befestigt. Der Prüffinger 8 weist einen durch die Abtriebswelle der Schwenkeinheit 12 schwenkbaren Schwenkarm 15 auf, an dessen Ende ein Nadelhalter 16 zur Aufnahme einer hier nicht näher dargestellten Prüfnadel befestigt ist. Die Positioniereinheit 6 weist schließlich eine Hubeinheit 17 auf, welche den Prüffinger 8 absenken und anheben kann.

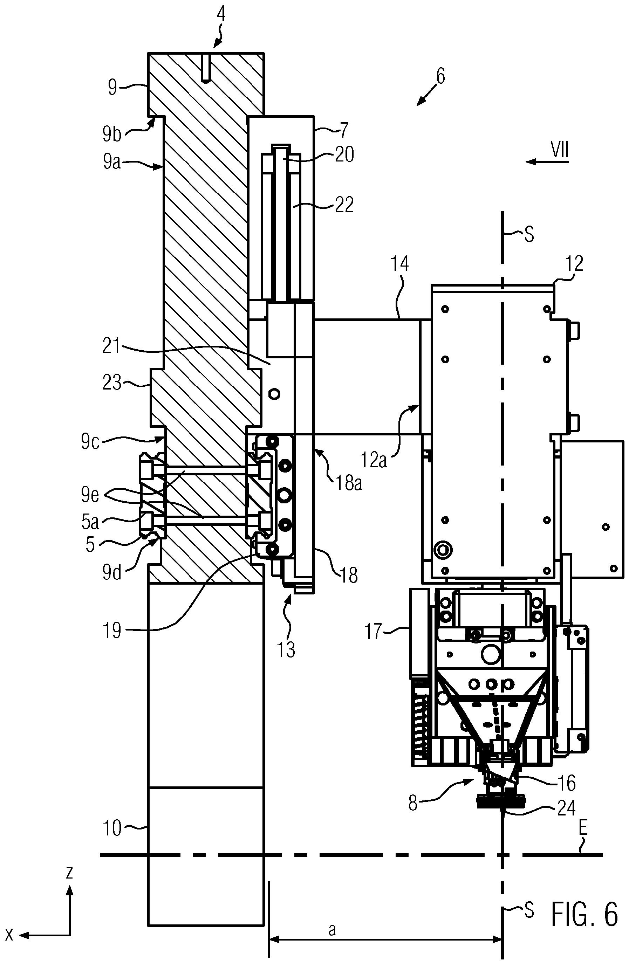

Eine noch detailliertere Darstellung ist in Fig. 6 gegeben, die einen in Fig. 5 durch eine strichpunktierte Linie "VI" angegeben Ausschnitt in einer noch weiter vergrößerten Ansicht zeigt. Genauer gesagt, zeigt der hier dargestellte Ausschnitt die obere Traverse 9 im Schnitt mit einem Holm 10 im Hintergrund und den an einer Seite der Traverse 9 angebrachten Anbauteilen. Es ist anzumerken, dass die andere Seite der Traverse in gleicher Weise bestückt ist.

Wie in Fig. 6 gezeigt, weist die Traverse 9 in jeder Seitenfläche (Vorder- und Rückseite) ausgebildet eine Stator-Aufnahmefläche 9a zur Aufnahme einer Statoreinheit 7 auf, wobei eine vertikale Lage (Lage in z-Richtung) der Statoreinheit 7 durch eine Oberkante 9b festgelegt ist. Die Statoreinheit 7 ist fest mit der Traverse 9 verschraubt.

Des Weiteren weist die Traverse 9 in jeder Seitenfläche ausgebildet eine Schienen-Aufnahmefläche 9c zur Aufnahme der als eine Schiene ausgebildeten Linearführung 5 auf, wobei eine vertikale Lage der Schiene 5 durch einen Absatz 9d nach unten festgelegt ist. In den Schienen-Aufnahmeflächen 9c sind Paare von (Durchgangs-) Bohrungen 9e vorgesehen, die mit Senkbohrungen 5a der Schienen 5 fluchten. Über die Durchgangsbohrungen 9e und Senkbohrungen 5a sind die Schienen (Linearführungen) 5 fest mit der Traverse 9 verschraubt.

Die Verfahreinheit 13 der Positioniereinheit 6 weist eine Grundplatte 18 auf. An der Grundplatte 18 sind ein Gleitschuh 19, eine Läufereinheit 20 und ein Weggeber 21 befestigt. Der Gleitschuh 19 umgreift die Schiene 5 in verschiebbarer Weise und bildet so mit der Schiene 5 eine Gleitlagerung. Es ist anzumerken, dass zur Vermeidung von Klemm-Momenten zwei Gleitschuhe 19 hintereinander angeordnet sein können. Die Läufereinheit 20 ragt nach oben in einen Innenraum der Statoreinheit 7 hinein und verläuft zwischen dort angeordneten Permanentmagneten 22, welche mit abwechselnder Polarität über die Länge der Statoreinheit 7 (in y-Richtung) verteilt sind. Die Läufereinheit 20 weist eine nicht näher dargestellte Spulenanordnung auf, welche über eine nicht näher dargestellte Stromzufuhr elektrisch erregbar sind. Durch elektrodynamische Wechselwirkung zwischen den Läuferspulen der Läufereinheit 20 und den Permanentmagneten 22 der Statoreinheit 7 erfolgt eine Beschleunigung oder Abbremsung und damit eine steuerbare Verschiebung der Verfahreinheit 13 entlang der Linearführung 5. Die Statoreinheit 7 und die Läufereinheit 20 jeder Positioniereinheit 6 bilden somit jeweils eine (Linear-) Antriebseinrichtung. Der Weggeber 21 weist zu einem an der Traverse 9 jeweils angebrachten Magnetband 23 hin und erlaubt durch Abtastung des Magnetbandes 23 eine exakte Bestimmung des Verfahrweges der Verfahreinheit 13 an der Traverse 9.

In der Figur ist eine Prüfnadel 24 (auch als Kontaktsonde 24 bezeichnet) zu sehen, die in dem Nadelhalter 16 des Prüffingers 8 gehalten wird und der Kontaktierung mit Prüfpunkten auf der nicht näher dargestellten Leiterplatte vorgesehen ist.

Die Grundplatte 18 der Verfahreinheit 13 weist eine Montagefläche 18a auf, und ein Gehäuse der Schwenkeinheit 12 weist eine Montagefläche 12a auf. Die Montageflächen 12a, 18a bilden eine Schnittstelle zur Befestigung der Schwenkeinheit 12 an der Verfahreinheit 18 mit einem dazwischen angeordneten Distanzstück 14. (Die Montageflächen 12a, 18a erlauben auch eine Befestigung der Schwenkeinheit 12 an der Verfahreinheit 18 ohne dazwischen angeordnetes Distanzstück 14; dies ist Gegenstand der ersten Befestigungsart, die weiter unten näher erläutert werden wird.) Zwischen der Schwenkachse S der Schwenkeinheit 12 und einer Außenfläche der Schiene (Linearführung) 5 stellt sich ein Abstand a ein, der neben den Abmessungen der Schwenkeinheit 12 und der Verfahreinheit 13 wesentlich von der Stärke des Distanzstücks 14 abhängig ist.

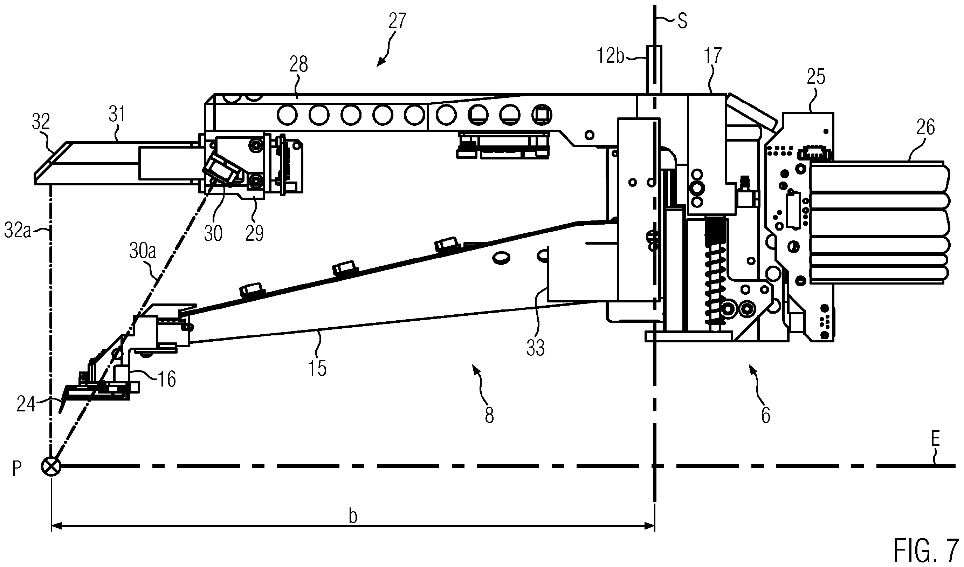

Fig. 7 zeigt einen unteren Teil der Positioniereinheit 6 mit dem Prüffinger 8 in Richtung eines Pfeils "VII" in Fig. 5. Genauer gesagt zeigt Fig. 6 nur die Hubeinheit 17 der Positioniereinheit 6 und eine Abtriebswelle 12b der ansonsten in dieser Darstellung weggelassenen Schwenkeinheit 12 (vgl. Fig. 6).

Gemäß der Darstellung in Fig. 7 ist an der Hubeinheit 17 eine Elektroanschlusseinheit 25 angebracht, an welchem ein Kabelzuführungsband 26 zur Verbindung mit einer nicht näher dargestellten Anlagensteuerung angeschlossen ist.

Der Prüffinger 8 und eine nachstehend näher beschriebene Detektionseinheit 27 sind durch die Schwenkeinheit (Abtriebsachse 12b) gemeinsam schwenkbar. Der Prüffinger 8 und die Detektionseinheit 27 sind möglichst leicht ausgeführt, um die trägen Massen und Trägheitsmomente gering zu halten. Daher ist der Schwenkarm 15 auch aus einem Carbonmaterial hergestellt.

Die Detektionseinheit 27 weist einen Haltearm 28 auf, der an seinem Ende ein Kameramodul 29 trägt, in welchem eine Kamera 30 angeordnet ist. In weiterer Verlängerung des Haltearms 28 ist eine Lichtlenkeinheit 31, die einen Spiegel 32 trägt, an dem Kameramodul 29 befestigt. Der Spiegel 32 ist so ausgerichtet, dass eine von dem Spiegel 32 aus rechtwinklig auf die Prüfebene E fallende optische Achse 32a sich zu der Kameraeinheit 29 fortsetzt. Die Kamera 30 ist so ausgerichtet, dass ihre optische Achse 30a auf der Prüfebene E mit der optischen Achse 32a des Spiegels 32 zusammenfällt. Der Schnittpunkt der optischen Achsen 30a, 32a fällt mit einem Abtastpunkt P, der durch die Prüfnadel 24 abzutasten ist, zusammen.

Die Hubeinheit 17 ist an der Schwenkeinheit 12 fest moniert und weist eine Mimik (nicht näher bezeichnet) auf, die so ausgebildet ist, dass die Detektionseinheit 27 in der Mimik drehbar gelagert ist und in der Höhe (z-Position) unveränderlich gehalten wird, von der Abtriebswelle 12a des Schwenkantriebs aber in Schwenkrichtung mitgenommen werden kann. Der Prüffinger 8 ist mit einem Hubantrieb (Linearantrieb, nicht näher bezeichnet) der Hubeinheit 17 abtriebsseitig verbunden und auf der Abtriebswelle 12a des Schwenkantriebs axial fliegend, aber drehfest gelagert, sodass der Prüffinger 8 durch den Hubantrieb absenk- und anhebbar ist, während er von einer Drehbewegung der Abtriebswelle 12a des Schwenkantriebs mitgenommen wird. In der Figur ist die Anordnung so gezeigt, dass die Prüfnadel 24 von der Prüfebene E abgehoben ist.

In einer Ausführungsvariante kann der Hubantrieb selbst auf einer mitschwenkenden Halterung des Schwenkarms 15 des Prüffingers 8 angeordnet und sich abtriebsseitig an einer Mimik zur Lagerung der Detektionseinheit 27 abstützen. In einer weiteren Ausführungsvariante ist eine Hubeinheit fest mit der Verfahreinheit verbunden und ist die Schwenkeinheit an einer Abtriebsseite der Hubeinheit befestigt. In beiden Ausführungsvarianten werden aber die trägen Massen bezüglich der Hubbewegung (z-Bewegung) erhöht.

Wie in Fig. 7 gezeigt, ist der Schwenkarm 15 des Prüffingers 8 antriebsseitig in einer Schwenkarmhalterung 33 befestigt und sensorseitig mit dem Nadelhalter 16 verbunden. An diesen beiden Stellen kann der Schwenkarm 15 gelöst werden, sodass ein Austausch des Schwenkarms 15 leicht möglich ist. Gleichermaßen kann der Haltearm 28 der Detektionseinheit 27 von Anschlussstellen an der Mimik des Hubantriebs 17 und an dem Kameramodul 29 gelöst werden und ebenfalls leicht ausgetauscht werden. Auf diese Weise ist eine Anpassung der Prüfeinheit 1 möglich, die nachstehend anhand der Fign. 8 bis 10 in Bezug auf die bereits im Zusammenhang mit Fig. 3 erwähnte erste Montageart der Traverseneinheit 2 beschrieben wird.

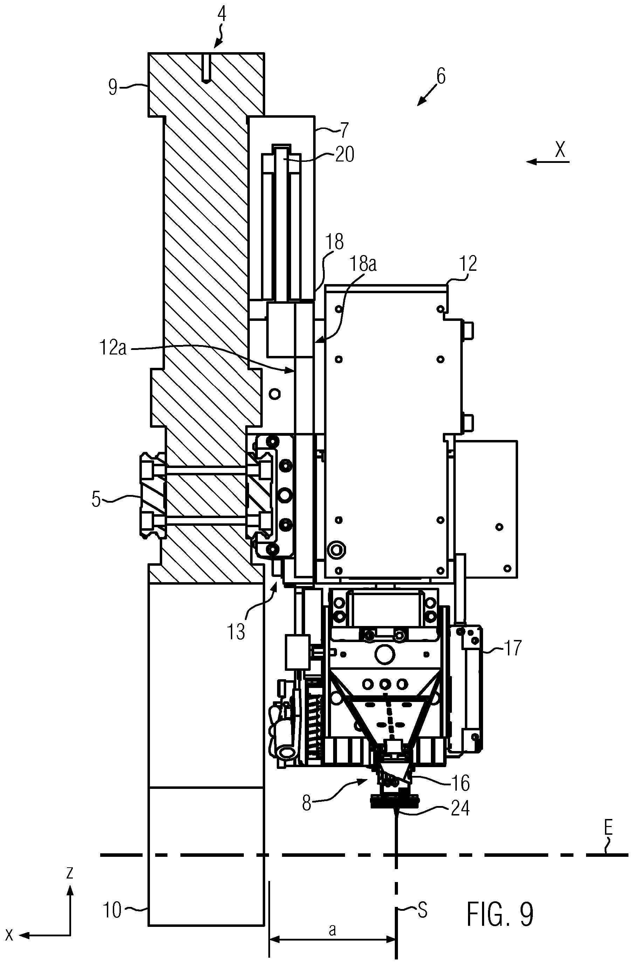

Dabei zeigt Fig. 8 einen Ausschnitt, der in Fig. 4 durch eine strichpunktierte Linie "VIII" angegeben ist, in einer vergrößerten Ansicht entsprechend Fig. 5, zeigt Fig. 9 einen in Fig. 8 durch eine strichpunktierte Linie "IX" angegeben Ausschnitt in einer noch weiter vergrößerten Ansicht entsprechend Fig. 6 und zeigt Fig. 7 einen unteren Teil der Positioniereinheit 6 mit dem Prüffinger 8 in Richtung eines Pfeils "X" in Fig. 9 in einer Ansicht entsprechend Fig. 7. Es ist anzumerken, dass Schwenkstellungen jeweiliger Prüffinger 8 in den Fign. 8 bis 10 sich von denjenigen in Fig. 3 unterscheiden können.

Wie aus den Figuren ersichtlich, ist der Aufbau der Traverseneinheit 2 in dieser ersten Montageart identisch mit der zweiten Montageart gemäß Fign. 4 bis 7 bis auf den Unterschied, dass die Schwenkeinheit 12 mit ihrer Montagefläche 12a ohne ein Distanzstück direkt an der Montagefläche 18a der Grundplatte 18 der Verfahreinheit 13 montiert ist und des Weiteren der Schwenkarm 15 des Testfingers 8 wie auch der Haltearm 28 der Detektionseinheit 27 kürzer als in der zweiten Montageart sind. Hierdurch ist die Abtastbreite w (vgl. Fig. 3) der Prüffinger 8 jeder Traverseneinheit 2 kleiner als in der zweiten Montageart (vgl. Fig. 4), und auf dem durch die zwei Bodenbalken 3 gebildeten Gestell können zwei statt nur einer Traverseneinheit 2 angeordnet werden. Dadurch wird die Abtastdichte der Prüffinger 8 erhöht, und in gleicher Zeit können mehr Prüfpunkte abgetastet werden. Mit anderen Worten, der Durchsatz der Prüfvorrichtung 1 steigt.

Somit ist auch eine Umrüstung der Prüfvorrichtung 1 von niedrigem zu hohem Durchsatz und umgekehrt auf einfache Weise möglich. Sofern eine Prüfvorrichtung 1 mit nur einer Traverseneinheit 2 gemäß der zweiten Montageart (Fign. 4 bis 7) vorhanden ist, erfordert ein Umbau der Prüfvorrichtung 1 für einen höheren Durchsatz nur ein Umsetzen der bereits vorhandenen Traverseneinheit 2 von den Auflagenflächen 3c zu den Auflageflächen 3a (oder 3b) der Bodenbalken 3, einen Austausch der Schwenkarme 15 und der Tragarme 27 durch jeweils kürzere Exemplare nebst Entfernen der Distanzstücke 14, und den Einbau einer weiteren Traverseneinheit mit kurzen Schwenkarmen 15 und Tragarmen 27 und ohne Distanzstücke auf den jeweils freien der Auflageflächen 3a, 3b der Bodenbalken 3. Eine Prüfvorrichtung 1 mit zwei Traverseneinheiten 2 gemäß der ersten Montageart (Fign. 1 bis 3, 8 bis 10) kann mit vergleichsweise geringem Aufwand in zwei Prüfvorrichtungen mit jeweils einer Traverseneinheit 2 gemäß der zweiten Montageart umgebaut werden, indem ein weiteres Gestell (Bodenbalken 3) bereitgestellt wird, eine der Traverseneinheiten 2 aus der bereits vorhandenen Prüfvorrichtung 1 auf das neu bereitgestellte Gestell gesetzt und darauf montiert wird, die andere der Traverseneinheiten 2 der bereits vorhandenen Prüfvorrichtung 1 auf die mittleren Auflageflächen 3c umgesetzt wird, die Positioniereinheiten 6 durch Einbau von Distanzstücken 14 an der Schnittstelle 12a, 18a umgebaut wird, wobei an jeder der Positioniereinheiten 6 die Schwenkarme 15 und Tragarme 27 durch längere ersetzt werden, und schließlich das Förder- und Zuführungssystem für Leiterplatten angepasst wird. Die beiden so neu entstandenen Prüfvorrichtungen 1 arbeiten zwar mit jeweils geringerem Durchsatz als die alte Prüfvorrichtung 1, es kann jedoch sinnvoll sein, wenn zwei Arten von Leiterplatten gleichzeitig geprüft werden sollen.

Zur Vereinfachung der Umrüstung kann eine Zusammenstellung von Distanzstücken 14, Schwenkarmen 15 und Tragarmen 27 in einem gemeinsam Umbausatz für einen Rahmen 4 bzw. eine Traverseneinheit 2 zusammengefasst werden, wobei der Umbausatz für die richtige Zuordnung allein durch die Abtastbreite w der Traverseneinheit 2 gekennzeichnet werden muss. Für die kleinste Abtastbreite w können die Distanzstücke 14 in dem Umbausatz weggelassen werden.

Es versteht sich, dass nicht nur zwei Abtastbreiten w möglich sind, sondern beliebige Stufen von Abtastbreiten w je nach Anzahl der in einem Gestell montierbaren Traverseneinheiten 2 und der auf dem Gestell vorgesehenen Auflageflächen (Montagestellen).

Vorstehend wurde eine Prüfvorrichtung 1 in zwei Montagearten beschrieben, bei welcher die Prüffeldebene E horizontal in angeordnet ist. Es ist gleichermaßen denkbar, dass die Prüfebene E in einem beliebigen Winkel zum Erdschwerefeld angeordnet ist. Alle Richtungsangaben in dieser Anmeldung sind so zu verstehen, dass die Prüffeldebene E die Horizontale (xy) definiert und eine Richtung senkrecht dazu die Vertikale (z), unabhängig von der geografischen Lage im Schwerefeld.

Die Hubeinheit weist im vorliegenden Ausführungsbeispiel einen Linearmotor als Hubmotor auf. Alternativ kann die Hubeinheit einen Kolben, magnetisch, pneumatisch oder hydraulisch betätigt, oder ein Bewegungsgewinde aufweisen oder auf ganz andere Art aufgebaut sein. Die Schwenkeinheit 12 weist in dem vorliegenden Ausführungsbeispiel einen Schrittmotor als Schwenkmotor auf. Alternativ kann die Schwenkeinheit 12 einen Kolben oder einen Linearmotor mit einem gekrümmten Bewegungsverlauf aufweisen.

### Bezuqszeichenliste

- 1: Prüfvorrichtung
- 2: Traverseneinheit
- 3: Montagebalken (Gestell)
- 3a, 3b, 3c: Auflageflächen
- 4: Traverseneinheit (Rahmen)
- 5: Schiene (Linearführung)
- 5a: Senkbohrung
- 6: Positioniereinheit
- 7: Statoreinheit (Linear-Antriebseinrichtung)
- 8: Prüffinger
- 9: Traverse
- 9a: Stator-Aufnahmefläche
- 9b: Oberkante
- 9c: Schienen-Aufnahmefläche
- 9d: Absatz
- 9e: Bohrung
- 10: Holm (Verbindungsstück)
- 11: Endanschlag
- 12: Schwenkeinheit
- 12a: Montagefläche
- 12b: Abtriebswelle
- 13: Schlitten (Verfahreinheit)
- 14: Distanzstück
- 15: Schwenkarm
- 16: Nadelhalter
- 17: Hubeinheit
- 18: Grundplatte
- 18a: Montagefläche
- 19: Gleitschuh
- 20: Läufereinheit (Linear-Antriebseinrichtung)
- 21: Weggeber
- 22: Permanentmagnet (Statoreinheit)
- 23: Magnetband
- 24: Prüfnadel (Kontaktsonde)
- 25: Elektroanschlusseinheit
- 26: Kabelzuführungsband
- 27: Detektionseinheit
- 28: Haltearm
- 29: Kameramodul
- 30: Kamera
- 30a: Optische Achse
- 31: Lichtlenkeinheit
- 32: Spiegel
- 32a: Optische Achse
- 33: Schwenkarmhalterung

- a: Achsabstand
- b: Sensorabstand
- r: Rahmenabstand
- w: Abtastbreite
- x, y, z: Raumrichtungen
- x: Längsrichtung (Laderichtung)
- y: Querrichtung
- z: Hochrichtung

- E: Prüfebene
- P: Abtastpunkt
- S: Schwenkachse

Die vorstehende Liste der Bezugszeichen und Symbole ist Bestandteil der Beschreibung.

## Patentansprüche

1. Traverseneinheit (2) für eine Prüfvorrichtung (1) für Leiterplatten, wobei die Traverseneinheit (2) wenigstens eine ein Prüffeld, in dem eine zu prüfende Leiterplatte angeordnet werden kann, überspannende Traverse (9) aufweist und ausgebildet ist, um Positioniereinheiten (6) für Testfinger (8) in einer linear verfahrbaren Weise derart aufzunehmen, dass die Testfinger (8) zumindest einen Teil des Prüffelds abtasten können, und die Traverseneinheit (2) eine feste Einheit bildende Raumform besitzt,
**dadurch gekennzeichnet, dass**
die Traverseneinheit (2) ausgebildet ist, wenigstens zwei voneinander unabhängige Linearführungen (5) zum Führen von jeweils wenigstens einer der Positioniereinheit (6) aufzunehmen, wobei die Linearführungen (5) jeweils als Schiene ausgebildet sind.

2. Traverseneinheit (2) nach einem der vorstehenden Ansprüche,
**dadurch gekennzeichnet, dass**
die Linearführungen (5) seitlich an jeweiligen Traversen (9) vorgesehen sind.

3. Traverseneinheit (2) nach Anspruch 1 oder 2,
**dadurch gekennzeichnet, dass**
wenigstens eine der Traversen (9) zwei der Linearführungen (5) aufweist, wobei die zwei Linearführungen (5) parallel zueinander verlaufen.

4. Traverseneinheit (2) nach einem der Ansprüche 1 bis 3,
**dadurch gekennzeichnet, dass**
die Traverseneinheit (2) wenigstens zwei das Prüffeld überspannende Traversen (9) aufweist, wobei jede der wenigstens zwei Traversen (9) wenigstens eine der Linearführungen (5) aufweist, wobei die wenigstens zwei Traversen (9) vorzugsweise parallel zueinander verlaufen.

5. Traverseneinheit (2) nach Anspruch 4,
**dadurch gekennzeichnet, dass**
von den wenigstens zwei Traversen (9) wenigstens eine auf einer Seite einer Prüffeldebene (E) des Prüffeldes verläuft und wenigstens eine auf einer anderen Seite der Prüffeldebene (E) verläuft.

6. Traverseneinheit (2) nach Anspruch 5,
**dadurch gekennzeichnet, dass**
die wenigstens zwei Traversen (9) genau zwei Traversen (9) sind, die durch Verbindungsstücke (10) zu einer Ringform (4) von wenigstens im Wesentlichen rechteckigem Verlauf, vorzugsweise einstückig, verbunden sind, so dass die Traverseneinheit (2) das Prüffeld derart umspannt, dass das Prüffeld zwischen den zwei Traversen (9) angeordnet ist.

7. Traverseneinheit (2) nach einem der vorstehenden Ansprüche,
**dadurch gekennzeichnet, dass**
die Traverseneinheit (2) vorbereitet ist, um an vorgegebenen Anschlusspunkten (3a, 3b, 3c) eines Gestells (3) der Prüfvorrichtung (1) fest montiert zu werden.

8. Traverseneinheit (2) nach einem der vorstehenden Ansprüche,
**dadurch gekennzeichnet, dass**
die Positioniereinheit (6) jeweils eine Schwenkeinheit (12) und eine Verfahreinheit (13) aufweisen, wobei die Testfinger (8) jeweils einen mit der Schwenkeinheit (12) einer zugehörigen Positioniereinheit (6) verbundenen Schwenkarm (15) und eine am Schwenkarm (15) befestigte Prüfsonde (24) aufweisen, wobei die Verfahreinheit (13) jeweils in einer der Linearführungen (5) gelagert und durch eine Antriebseinrichtung (7, 20) verfahrbar ist, und wobei die Linearführungen (5) an der Traverseneinheit (2) befestigt sind.

9. Traverseneinheit (2) nach Anspruch 8,
**dadurch gekennzeichnet, dass**
ein Achsabstand (a) der Schwenkachse (A) der Schwenkeinheit (12) der Positioniereinheiten (6) von der jeweiligen Linearführung (5) und/oder ein Sondenabstand (b) einer Prüfsonde (24) von der Schwenkachse (A) der Schwenkeinheit (12) einer jeweiligen Positioniereinheit (6) veränderbar ist, wobei der Achsabstand (a) bzw. der Sondenabstand (b) vorzugsweise in vorgegebenen Stufen veränderbar ist.

10. Traverseneinheit (2) nach Anspruch 9,
**dadurch gekennzeichnet, dass**
Verbindungsflächen (12a, 18a) zweier baulicher Bestandteile der Positioniereinheit (6) als eine Schnittstelle zur Veränderung des Achsabstands (a) ausgebildet sind, wobei vorzugsweise Distanzstücke (14) vorgegebener Stärke zur Veränderung des Achsabstands (a) zwischen den Verbindungsflächen anbringbar (12a, 18a) sind.

11. Traverseneinheit (2) nach Anspruch 9 oder 10,
**dadurch gekennzeichnet, dass**
zur Veränderung des Sondenabstands (b) Schwenkarme (15) unterschiedlicher Längen vorgesehen sind, die zwischen der Schwenkachse (A) und der Prüfsonde (24) montierbar sind.

12. Traverseneinheit (2) nach Anspruch 11,
**dadurch gekennzeichnet, dass**
der Sondenabstand (b) an den jeweiligen Achsabstand (a) anpassbar ist, wobei insbesondere Distanzstücke (14) zur Festlegung des Achsabstands (a) und Schwenkarme (15) zur Festlegung des Sondenabstands (b) mit aneinander angepassten Distanzstück-Stärken bzw. Schwenkarm-Längen vorgesehen sind.

13. Prüfvorrichtung (1) für Leiterplatten mittels Testfingern (8), wobei die Testfinger (8) so gelagert und verfahrbar sind, dass ein Prüffeld, in dem eine zu prüfende Leiterplatte angeordnet werden kann, durch die Testfinger (8) abgetastet werden kann,
**dadurch gekennzeichnet, dass**
die Prüfvorrichtung (1) wenigstens eine Traverseneinheit (2) gemäß einem der vorstehenden Ansprüche aufweist.

14. Prüfvorrichtung (1) nach Anspruch 13,
**dadurch gekennzeichnet, dass**
die Prüfvorrichtung (1) ein ortsfestes Gestell (3) aufweist, wobei das Gestell (3) eine Mehrzahl von Anschlusspunkten (3a, 3b, 3c) aufweist, die eine Befestigung der wenigstens einen Traverseneinheit (2) an unterschiedlichen Positionen relativ zu dem Prüffeld ermöglicht.

## Claims

1. Crossmember unit (2) for a test apparatus (1) for printed circuit boards wherein the crossmember unit (2) has at least one crossmember (9) spanning a test field in which a circuit board to be tested may be placed, and is designed to hold positioning units (6) for test fingers (8) in a linearly traversable manner so that the test fingers (8) are able to scan at least part of the test field, and the crossmember unit (2) has a three-dimensional shape forming a solid unit
**characterised in that**
the crossmember unit (2) is designed to hold at least two linear guides (5), independent of one another, for guiding in each case at least one of the positioning units (6), wherein the linear guides are respectively formed as rails.

2. Crossmember unit (2) according to any of the preceding claims,
**characterised in that**
the linear guides (5) are provided at the side of each crossmember (9).

3. Crossmember unit (2) according to claim 1 or 2
**characterised in that**
at least one of the crossmembers (9) has two linear guides (5), with the two linear guides (5) running parallel to one another.

4. Crossmember unit (2) according to any of claims 1 to 3,
**characterised in that**
the crossmember unit (2) has at least two crossmembers (9) spanning the test field, wherein each of the two or more crossmembers (9) has at least one of the linear guides (5), wherein the two or more crossmembers (9) preferably run parallel to one another.

5. Crossmember unit (2) according to claim 4
**characterised in that**
of the two or more crossmembers (9), at least one runs on one side of a test field plane (E) of the test field and at least one runs on the other side of the test field plane (E).

6. Crossmember unit (2) according to claim 5,
**characterised in that**
the two or more crossmembers (9) are exactly two crossmembers (9), joined by connection pieces (10) to form an annular shape (4) of at least substantially rectangular pattern, preferably in one piece, so that the crossmember unit (2) spans the test field in such a way that the test field is positioned between the two crossmembers (9).

7. Crossmember unit (2) according to any of the preceding claims **characterised in that**
the crossmember unit (2) is prepared for fixed mounting at preset connection points (3a, 3b, 3c) of a stand (3) of the test apparatus (1).

8. Crossmember unit (2) according to any of the preceding claims **characterised in that**
each positioning unit (6) has a swivel unit (12) and a traversing unit (13), wherein each test finger (8) has a swivel arm (15) joined to the swivel unit (12) of an associated positioning unit (6) and a test probe (24) fastened to the swivel arm (15), wherein each traversing unit (13) is mounted in one of the linear guides (5) and may be made to traverse by a drive unit (7, 20), and wherein the linear guides (5) are mounted on the crossmember unit (2).

9. Crossmember unit (2) according to claim 8,
**characterised in that**
an axial distance (a) of the swivel axis (A) of the swivel unit (12) of the positioning units (6) from the respective linear guide (5) and/or a probe distance (b) of a test probe (24) from the swivel axis (A) of the swivel unit (12) of a particular positioning unit (6) is changeable, wherein the axial distance (a) and/or the probe distance (b) are preferably changeable in preset steps.

10. Crossmember unit (2) according to claim 9
**characterised in that**
connection surfaces (12a, 18a) of two structural elements of the positioning unit (6) are designed as an interface for changing the axial distance (a), wherein preferably spacers (14) of preset thickness may be fitted to change the axial distance (a) between the connection surfaces (12a, 18a).

11. Crossmember unit (2) according to claim 9 or 10
**characterised in that**
swivel arms (15) of different lengths are provided for changing the probe distance (b), and may be mounted between the swivel axis (A) and the test probe (24).

12. Crossmember unit (2) according to claim 11
**characterised in that**
the probe distance (b) may be adapted to the respective axial distance (a), wherein in particular spacers (14) for fixing the axial distance (a) and swivel arms (15) for fixing the probe distance (b) are provided with matching spacer thicknesses and swivel arm lengths respectively.

13. Test apparatus (1) for printed circuit boards using test fingers (8), wherein the test fingers (8) are so mounted and traversable that a test field in which a circuit board to be tested may be positioned can be scanned by the test fingers (8)
**characterised in that**
the test apparatus (1) has at least one crossmember unit (2) according to one of the above claims.

14. Test apparatus (1) according to claim 13.
**characterised in that**
the test apparatus (1) has a stationary stand (3), wherein the stand (3) has a multiplicity of connection points (3a, 3b, 3c) which facilitate fastening of the crossmember unit or units (2) in different positions relative to the test field.

## Revendications

1. Unité de traverses (2) pour un dispositif de test (1) pour circuits imprimés, dans laquelle l'unité de traverses (2) comporte au moins une traverse (9) couvrant un champ de test dans lequel une carte de circuit imprimé peut être disposée et qui est formée pour recevoir des unités de positionnement (6) pour doigts de test (8) déplaçable d'une manière linéaire de façon à ce que les doigts de test ouvrirent parenthèse 8) peuvent au moins balayer une partie du champ de test et que l'unité de traverses (2) a une forme tridimensionnelle formant une unité solide,
**caractérisée en ce que**
l'unité de traverses (2) et formée pour recevoir au moins deux guidages linéaires (5) indépendants l'un de l'autre pour le guidage de respectivement une des unités de positionnement (6) dans laquelle les guidages linéaires sont respectivement formés en tant que rails.

2. Unité de traverses (2) selon l'une quelconque des revendications précédentes,
**caractérisée en ce que**
les guidages linéaires (5) sont prévus sur le côté de traverses (9) respectives.

3. Unité de traverses (2) selon la revendication 1 ou 2,
**caractérisée en ce que**
au moins l'une des traverses (9) comporte deux guidages linéaires (5), dans laquelle les deux guidages linéaires (5) s'étendent parallèlement l'un à l'autre.

4. Unité de traverses (2) selon l'une quelconque des revendications 1 à 3,
**caractérisée en ce que**
l'unité de traverses (2) comporte au moins deux traverses (9) enjambant le champ de test (9), chacune des au moins deux traversées (9) comportant au moins un des guidages linéaires, dans lequel les au moins deux traverses (9) s'étendent de préférence parallèlement l'une à l'autre.

5. Unité de traverses (2) selon la revendication 4,
**caractérisée en ce qu'**au moins l'une des au moins deux traverses (9) s'étend d'un côté d'un plan de champ de test (E) du champ de test et au moins l'une s'étend d'un autre côté du plan de champ de test (E).

6. Unité de traverses (2) selon la revendication 5,
**caractérisée en ce que**
les au moins deux traverses (9) sont exactement deux traverses (9) reliées par des pièces de liaison (10) à une forme annulaire (4) au moins sensiblement rectangulaire, de préférence en une seule pièce sont, de sorte que l'unité de traverses (2) s'étend autour du champ de test de telle sorte que le champ de test est disposé entre les deux traverses (9).

7. Unité de traverses (2) selon l'une quelconque des revendications précédentes,
**caractérisée en ce que**
l'unité de traverses (2) est préparé pour être monté de façon fixe sur des points de connexion prédéterminés (3a, 3b, 3c) d'un châssis (3) du dispositif de test (1).

8. Unité de traverses (2) selon l'une quelconque des revendications précédentes,
**caractérisée en ce que**
les unités de positionnement (6) comportant chacune une unité de pivotement (12) et une unité de voie (13), les doigts de test (8) comportant respectivement un bras de pivotement (15) étant connecté avec l'unité de pivotement (12) d'une unité de positionnement (6) y appartenant et une sonde de test (24) fixée au bras de pivotement (15), dans laquelle chaque unité de voie (13) est en palier sur un des guidages linéaires (5) et peut être déplacé par le moyen d'un dispositif d'entraînement (7, 20), et dans lequel les guidages linéaires (5) sont fixées à l'unité de traverses (2).

9. Unité de traverses (2) selon la revendication 8,
**caractérisée en ce**
**qu'**une distance axiale (a) de l'axe de pivotement (A) de l'unité de pivotement (12) des unités de positionnement (6) du guidage linéaire respectif (5) et / ou d'une distance de sonde(b) de sonde de test (24) de l'axe de pivotement (A) de l'unité de pivotement (12) d'une unité de positionnement (6) respective et échangeable, dans laquelle la distance axiale (a) ou la distance de sonde (b) est de préférence variable dans des étapes prédéterminées.

10. Unité de traverses (2) selon la revendication 9,
**caractérisée en ce que**
des surfaces de liaison (12a, 18a) de deux composants structuraux de l'unité de positionnement (6) sont configurées en tant qu'une interface pour le changement de la distance axiale (a), dans laquelle de préférence des pièces de distance (14) de taille prédéterminée peuvent être disposées entre les surfaces de liaison (12a, 18a) pour le changement de la distance axiale (a).

11. Unité de traverses (2) selon la revendication 9 ou 10,
**caractérisée en ce que**
pour le changement de la distance de sonde (b) des bras de pivotement (15) de longueurs différentes sont prévus, lesquels peuvent être montées entre l'axe de pivotement (A) et la sonde de test (24).

12. Unité de traverses (2) selon la revendication 11,
**caractérisée en ce que**
la distance de sonde (b) peut être adapté à la distance axiale (a) respectives, dans laquelle sont prévus en particulier des pièces de distance (14) pour la détermination de la distance axiale (a) et des bras de pivotement (15) pour la détermination de la distance de sonde (b) avec des tailles de pièces de distance ou des longueurs de bras de pivotement adaptées les unes aux autres.

13. Dispositif de test (1) pour circuits imprimés au moyen de doigts de test (8), dans lequel les doigts de test (8) sont montés et déplacés de manière à pouvoir balayer une carte de circuit imprimé à tester par les doigts de test (8),
**caractérisée en ce que**
le dispositif de test (1) comporte au moins une unité de traverses (2) selon l'une quelconque des revendications précédentes.

14. Dispositif de test (1) selon la revendication 13,
**caractérisée en ce que**
le dispositif de test (1) comporte un cadre fixe (3), le cadre (3) comportant plusieurs points de connexion (3a, 3b, 3c), qui permet la fixation de l'au moins une unité de traverses (2) à différentes positions par rapport au champ de test.
